# EUROPEAN PATENT APPLICATION

(11) **EP 2 500 955 A1**
(43) Date of publication of application: **19.09.2012**
(21) Application number: 10830029.4
(22) Date of filing: 12.11.2010
(51) Int. Cl.: H01L 33/48, H01L 23/12, H01L 23/36

(54) **SUBSTRATE FOR LIGHT-EMITTING ELEMENTS AND LIGHT-EMITTING DEVICE**

(30) Priority: 13.11.2009 JP 2009259449
(71) Applicant: Asahi Glass Company, Limited, Tokyo 100-8405 (JP)
(72) Inventor: NAKAYAMA, Katsuyoshi, Tokyo 100-8405 (JP)
(74) Representative: Müller-Boré & Partner Patentanwälte
(86) International application number: PCT/JP2010/070233
(87) International publication number: WO 2011/059070

(57) **Abstract**

To provide a substrate for light-emitting element, which is excellent in the planarity of the mounting surface to be provided with a light-emitting element, has a low heat resistance and can suppress the tilt of the light-emitting element.

A substrate for light-emitting element, which comprises a substrate main body 2 made of a sintered product of a glass ceramics composition comprising a glass powder and a ceramics filler and having a mounting surface 21, of which a part constitutes a mounting portion 22 on which a light-emitting element is to be mounted, and thermal vias 6 embedded in the substrate main body 2 and extending from a non-mounting surface 23 which is a surface opposite to the mounting surface 21 to the vicinity of the mounting surface 21 so as not to be in contact with the mounting surface 21.

## Description

### TECHNICAL FIELD

The present invention relates to a substrate for light-emitting element and a light-emitting device employing it, particularly to a substrate for light-emitting element which is excellent in the planarity of a mounting surface on which a light-emitting element is mounted, and a light-emitting device employing it.

### BACKGROUND ART

In recent years, along with a tendency to high brightness and whitening of a light-emitting diode element (chip), a light-emitting device employing a light-emitting diode element has been used for backlights of mobile phones or liquid crystal TVs, etc. However, along with a tendency to high brightness of a light-emitting diode element, heat generation is also increasing, and the temperature increases excessively, whereby adequate emission brightness has not necessarily been obtainable. Therefore, as a substrate for light-emitting element capable of mounting a light-emitting element such as a light-emitting diode element, one capable of readily dissipating heat generated from the light-emitting element and capable of obtaining sufficient emission brightness, has been desired.

Heretofore, as a substrate for a light-emitting element, an alumina substrate has, for example, been used. However, the thermal conductivity of the alumina substrate is not necessarily high at a level of from about 15 to 20 W/m·K. Accordingly, it is also studied to employ an aluminum nitride substrate having a higher thermal conductivity.

However, the aluminum nitride substrate has drawbacks such that the cost of raw materials is high, and it is hardly sintered, whereby high temperature firing will be required, thus leading to an increase in the process cost. Further, the thermal expansion coefficient of the aluminum nitride substrate is as small as 4×10⁻⁶ to 5×10⁻⁶/°C, and when it is mounted on a printed substrate having a thermal expansion coefficient of at least 9×10⁻⁶/°C as a universal product, adequate connection reliability cannot necessarily be obtainable due to the difference in the thermal expansion.

In order to solve such problems, it has been studied to employ a low temperature co-fired ceramics substrate (hereinafter referred to as a LTCC substrate) as the substrate for light-emitting element. The LTCC substrate comprises, for example, glass and an alumina filler; the difference in their refractive indices is large; and their interfaces are many; and the thickness is larger than the wavelength to be used, whereby a high reflectance can be obtained. It is thereby possible to efficiently utilize light from the light-emitting element, and as a result, it is possible to reduce the quantity of heat generation. Further, it is composed of inorganic oxides which are less susceptible to deterioration by a light source, whereby a constant color can be maintained over a long period of time.

Further, such a LTCC substrate does not necessarily have a high thermal conductivity, and accordingly, it is known to reduce the thermal resistance, for example, by providing thermal vias made of a highly thermal conductive material such as a metal, so as to penetrate through from a mounting surface on which a light-emitting element is mounted to its opposite surface of a non-mounting surface. As such thermal vias, it is known to provide, for example, a plurality of them each having a size smaller than the light-emitting element or to provide only one thermal via having a size substantially equal to the light-emitting element (e.g. Patent Document 1).

### PRIOR ART DOCUMENT

### PATENT DOCUMENT

Patent Document 1: JP-A-2006-41230

### DISCLOSURE OF INVENTION

### TECHNICAL PROBLEM

However, in a case where thermal vias are formed, irregularities tend to be formed on a mounting surface. That is, since the optimum sintering temperature, the contraction behavior, etc. are different between a substrate main body mainly constructing an LTCC substrate and thermal vias embedded in the substrate main body, at a time of production, particularly at a time of sintering, such thermal vias protrude or sink from the mounting surface, whereby irregularities are formed. The protrusion of thermal vias is usually largest at the center of the thermal vias, and the larger the thermal vias (diameter or the like) are, the larger the protrusion is.

In general, a light-emitting element is fixed with an adhesive. If the mounting surface has irregularities, the amount of an adhesive tends to be large, whereby the heat resistance increases. Further, if the mounting surface has irregularities, a light-emitting element might be fixed at a tilt, and at a time of a subsequent wire bonding, the light emitting element might be damaged, or an optical axis might tilt.

The present invention has been made to solve the above problems, and it is an object of the present invention to provide a substrate for light-emitting element which is excellent in the planarity of a mounting surface on which a light-emitting element is mounted, has a low heat resistance and can suppress the tilt of the light-emitting element. Further, it is an object of the present invention to provide a light-emitting device comprising the above substrate for light-emitting element.

### SOLUTION TO PROBLEM

According to the study by the present inventors, it has been found that the planarity of a mounting surface can be improved by providing thermal vias so as not to be in contact with the mounting surface. Further, in a case where thermal vias are formed so as not to be in contact with a mounting surface, though the distance from a light-emitting element to the thermal vias increases, the adhesion of the light-emitting element improves, whereby the heat resistance can be reduced, as compared with conventional substrates. The present invention has been accomplished based on the above.

That is, the substrate for light-emitting element of the present invention comprises a substrate main body made of a sintered product of a glass ceramics composition comprising a glass powder and a ceramics filler and having a mounting surface, of which a part constitutes a mounting portion on which a light-emitting element is to be mounted, and thermal vias embedded in the substrate main body and extending from a non-mounting surface which is a surface opposite to the mounting surface to the vicinity of the mounting surface so as not to be in contact with the mounting surface.

The distance from the mounting surface to the thermal vias is preferably from 0.05 mm to 0.20 mm, more preferably from 0.05 mm to 0.15 mm. The difference in height between the highest part and the lowest part of the mounting portion is preferably at most 1 µm. Further, the mounting portion is preferably provided with a glass film having a surface roughness Ra of at most 0.4 µm.

For example, the ceramics filler is preferably an alumina powder, a zirconia powder or a mixture of an alumina powder and a zirconia powder. Further, the substrate main body preferably has a flexural strength of at least 250 MPa.

The light-emitting device of the present invention comprises the above substrate for light-emitting element of the present invention and a light-emitting element mounted thereon.

### ADVANTAGEOUS EFFECTS OF INVENTION

By the present invention, by providing thermal vias so as not to be in contact with the mounting surface, a substrate for light-emitting device which has an improved planarity of the mounting surface and a low heat resistance and can suppress the tilt of the light-emitting element can be provided. Further, according to the present invention, by providing such a substrate for light-emitting element with a light-emitting element, a light-emitting device can be provided, whereby a sufficient light-emitting brightness can be obtained and damage and the tilt of the optical axis of the light-emitting element are reduced.

### BRIEF DESCRIPTION OF DRAWINGS

Fig. 1 is a cross-sectional view illustrating an example of the substrate for light-emitting element of the present invention.
Fig. 2 is an enlarged cross-sectional view illustrating a part of the substrate for light-emitting element of the present invention shown in Fig. 1.
Fig. 3 is a cross-sectional view illustrating another example of the substrate for light-emitting element of the present invention.
Fig. 4 is a cross-sectional view illustrating an example of the light-emitting device of the present invention.
Fig. 5 a cross-sectional view illustrating another example of the light-emitting device of the present invention.

### DESCRIPTION OF EMBODIMENTS

Now, the present invention will be explained in detail.

The substrate for light-emitting element of the present invention comprises a substrate main body made of a sintered product of a glass ceramics composition comprising a glass powder and a ceramics filler and having a mounting surface, of which a part constitutes a mounting portion on which a light-emitting element is to be mounted, and thermal vias embedded in the substrate main body and extending from a non-mounting surface which is a surface opposite to the mounting surface to the vicinity of the mounting surface so as not to be in contact with the mounting surface.

In the present invention, thermal vias are formed so as not to be in contact with the mounting surface, that is, a mounting surface side on which thermal vias are formed is covered with the substrate main body, whereby the influence of the thermal vias on the mounting surface is reduced, and its planarity can be improved. In a case where the planarity is improved in such a manner, although the distance from the light-emitting element to the thermal vias becomes long, the adhesion when the light-emitting element is provided will be improved, and the heat resistance will be reduced, as compared with conventional substrates. Further, by improving the planarity, the tilt when the light-emitting element is provided can be reduced, damage or tilt of optical axis due to wire bonding can be reduced.

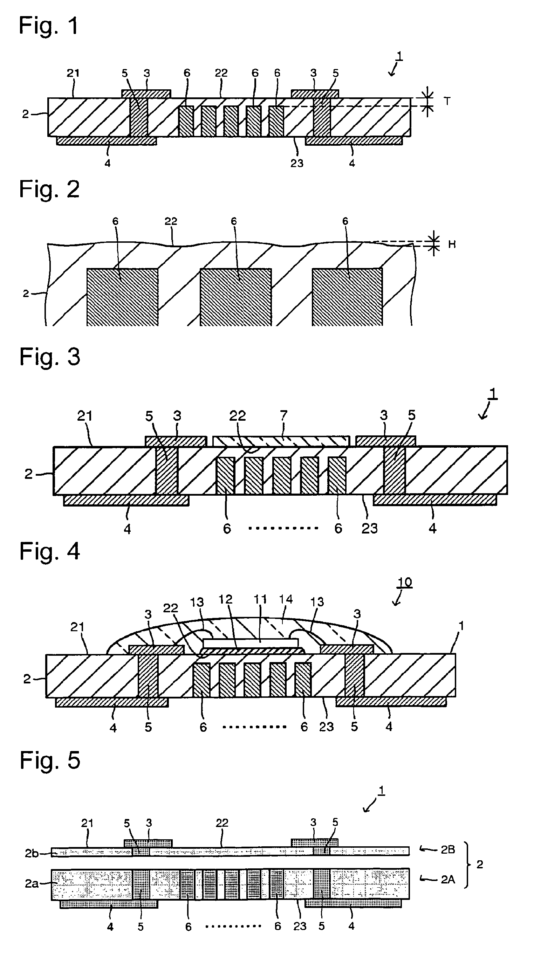

Fig. 1 is a cross-sectional view illustrating an example of the substrate 1 for light-emitting element of the present invention. The substrate 1 for light-emitting element has a substantially flat plate-form substrate main body 2 which mainly constitutes the substrate 1 for light-emitting element. The substrate main body 2 is made of a sintered product of a glass ceramics composition comprising a glass powder and a ceramic filler. One main surface (in Fig. 1, upper side) of the substrate main body 2 is a mounting surface 21 on which a light-emitting element is provided, and its substantially center part is a mounting portion 22 on which a light-emitting element is substantially provided. Further, the other main surface is a non-mounting surface 23 which is not provided with a light-emitting element. The substrate main body 2 preferably has a flexural strength of e.g. at least 250 MPa with a view to preventing damages, etc. during the mounting of light-emitting elements or during the use thereafter.

On the mounting surface 21, a connection terminal 3 is provided which are electrically connected to the light-emitting element. Further, on the non-mounting surface 23, an external electrode terminal 4 is provided which is electrically connected to an external circuit. Further, the inside of the substrate main body 2 is provided with a via conductor 5 which electrically connects the connection terminal 3 and the external electrode terminal 4.

The thermal vias 6 for reducing the heat resistance are embedded in the substrate main body 2. The thermal vias 6 may, for example, be columns smaller than the mounting portion 22, and plural thermal vias 6 are formed beneath the mounting portion 22. As already explained, the thermal vias 6 of the present invention are formed being from the non-mounting surface 21 to the vicinity of the mounting surface 21 so as not to be in contact with the mounting surface 21. With such a structure, the planarity of the mounting surface 21 particularly the mounting portion 22 can be improved, the heat resistance can be reduced, and the tilt when a light-emitting element is provided can be reduced.

Further, the thermal vias 6 are not necessarily formed beneath the mounting portion 22 and may be formed at the vicinity of the mounting portion 22. Further, the thermal vias 6 are not necessarily smaller than the mounting portion 22 and may be the substantially same size as the mounting portion 22.

The distance T from the mounting surface 21 to thermal vias 6 is preferably from 0.05 mm to 0.20 mm, more preferably from 0.05 mm to 0.15 mm. If the distance T is less than 0.05 mm, the mounting surface 21 may be influenced by the thermal vias 6, and its planarity may be insufficient. On the other hand, if the distance T exceeds 0.20 mm, particularly exceeds 0.15 mm, although the influence of the thermal vias 6 on the mounting surface 21 can be sufficiently reduced, the distance from the light-emitting element to the thermal vias 6 becomes too long, and the heat resistance may increase.

From the viewpoint of maintaining the sufficient planarity of the mounting surface 21 and reducing the distance from the light-emitting element to the thermal vias 6 to reduce the heat resistance, the distance T is preferably from 0.075 mm to 0.125 mm. Further, in a case where plural thermal vias 6 are formed, each of the thermal vias 6 preferably satisfies the above distance T.

Further, as shown in an enlargement Fig. 2, for example, the mounting portion 22 preferably has a difference H in height between the highest portion and the lowest portion of at most 1 µm. Here, the highest portion is the highest portion on the mounting portion 22, and the highest portion is usually a part where the thermal vias 6 are formed. On the other hand, the lowest portion is the lowest portion on the mounting portion 22, and the lowest portion is usually a part at the vicinity of the middle part of adjacent thermal vias 6. Further, the difference H in height is obtained as a height difference between the highest portion and the lowest portion.

The difference H in height is an index which represents the planarity. When such a difference H in height is at most 1 µm, the heat resistance is sufficiently low, and the tilt of the light-emitting element can be effectively reduced. The difference H in height is usually controlled by controlling the distance T from the mounting surface 21 to the thermal vias 6. For example, when the distance T is at least 0.05 mm, the difference H in height can be controlled to at most 1 µm.

Further, for example as shown in Fig. 3, the mounting portion 22 is preferably provided with a glass film 7 having a surface roughness Ra of at most 0.4 µm. Since conventional LTCC substrates have a surface roughness Ra of about 1.0 µm, by providing the mounting portion 22 with such a glass film 7, the planarity can be further improved. Further, since the glass film 7 usually has a lower reflectance than the substrate main body 2, it is preferred that the glass film 7 is provided at only the mounting portion 22, and the other parts are not provided with the glass film 7. Here, the surface roughness Ra is meant for an arithmetic mean roughness Ra, and the value of the arithmetic mean roughness Ra is one represented by JIS B0601 (1994), 3 "definition and representation of defined arithmetic mean roughness".

Up to here, the substrate 1 for light-emitting element of the present invention has been explained with reference to an example. However, so far as the object of the present invention is not impaired, or as the case requires, the construction of the invention can be appropriately modified. As already explained, the size (diameter, etc.), the number and the position of the thermal vias 6 can be appropriately changed. Further, the mounting surface 21 may be provided with a reflector or the like to reflect light of light-emitting element.

For example, as shown in Fig. 4, in the light-emitting device of the present invention, the mounting portion 22 of the substrate 1 for light-emitting element is provided with a light-emitting element 11 such as a light-emitting diode. The light-emitting element 11 is fixed on the mounting portion 22 with an adhesive 12, and electrodes not shown in Fig.4 are electrically connected to the connection terminal 3 through a bonding wire 13. Further, a mold material 14 is provided so as to cover the light-emitting element 11 and the bonding wire 13. Thus, the light-emitting device 10 is constituted.

In the light-emitting device 10 of the present invention, the substrate 1 for light-emitting element which has a small heat resistance is used, whereby an excessive heat increase of the light-emitting element 11 is reduced, and light can be emitted highly brightly. Further, since the tilt of the light-emitting element 11 can be reduced, its damage and the tilt of optical axis can be reduced. Such a light-emitting device 10 of the present invention can be preferably used as backlights for cell phones, large liquid crystal displays, etc., lights for vehicles or decorations or other light sources.

The substrate 1 for light-emitting element of the present invention is produced as follows.

Further, in the following explanation, materials to be used for its production are provided with the same symbols as their finished products.

For example, as shown in Fig. 5, the substrate 1 for light-emitting element is produced by producing a non-fired main body member 2A which has at least non-fired thermal vias 6 and which will mainly constitute a substrate main body 2 and also producing a non-fired cover member 2B which has no non-fired thermal vias 6 and which will constitute a mounting surface 21 of the substrate main body 2. Then, they are bonded to prepare a non-fired substrate 1 for light-emitting element, followed by carrying out binder burn out and firing.

The non-fired main body member 2A is, for example, produced by forming non-fired thermal vias 6 so as to penetrate both surfaces of a green sheet 2a for main body and forming a non-fired external electrode terminal 4 and a non-fired via conductor 5. Further, the non-fired cover member 2B is, for example, produced by only forming a non-fired connection terminal 3 and a non-fired via conductor 5 without forming a non-fired thermal via 6 on the green sheet 2b for cover. Here, as already explained, the distance T from the mounting surface 21 to the thermal via 6 on the substrate 1 for light-emitting element can be controlled by the thickness of the non-fired cover member 2B (green sheet 2b for cover).

The green sheet 2a for main body and the green sheet 2b for cover are prepared by preparing a slurry by adding a binder and as the case requires, a plasticizer, a solvent or the like to a glass ceramics composition comprising a glass powder (glass powder for substrate main body) and a ceramics filler, followed by molding it to a sheet form by a doctor blade method or the like and drying it.

The glass powder for the substrate main body is not necessarily limited, but one having a glass transition point (Tg) of at least 550°C and at most 700°C is preferred. If the glass transition point (Tg) is lower than 550°C, binder burn out tends to be difficult, and if it exceeds 700°C, the shrinkage start temperature tends to be high, whereby the dimensional precision is likely to deteriorate.

Further, it is preferred that when it is fired at a temperature of from 850°C to 900°C, crystals will precipitate. In the case of one where no crystal will precipitate, it is likely that no adequate mechanical strength can be obtained. Further, preferred is one having a crystallization peak temperature (Tc) of at most 880°C as measured by DTA (differential thermal analysis). If the crystallization peak temperature (Tc) exceeds 880°C, the dimensional precision is likely to deteriorate.

Such a glass powder for substrate main body is, for example, preferably one comprising from 57 mol% to 65 mol% of SiO₂, from 13 mol% to 18 mol% of B₂O₃, from 9 mol% to 23 mol% of CaO, from 3 mol% to 8 mol% of Al₂O₃ and from 0.5 mol% to 6 mol% in total of at least one selected from K₂O and Na₂O. By using such a glass powder, it becomes easy to improve the planarity of the mounting surface 21 of the substrate main body.

Here, SiO₂ will be a network former of glass. If the content of SiO₂ is less than 57 mol%, it tends to be difficult to obtain stabilized glass, and the chemical durability is likely to deteriorate. On the other hand, if the content of SiO₂ exceeds 65 mol%, the glass melting temperature or the glass transition point (Tg) tends to be too high. The content of SiO₂ is preferably at least 58 mol%, more preferably at least 59 mol%, particularly preferably at least 60 mol%. Further, the content of SiO₂ is preferably at most 64 mol%, more preferably at most 63 mol%.

B₂O₃ will be a network former of glass. If the content of B₂O₃ is less than 13 mol%, the glass melting point or the glass transition point (Tg) is likely to be too high. On the other hand, if the content of B₂O₃ exceeds 18 mol%, it tends to be difficult to obtain stable glass, and the chemical durability is also likely to deteriorate. The content of B₂O₃ is preferably at least 14 mol%, more preferably at least 15 mol%. Further, the content of B₂O₃ is preferably at most 17 mol%, more preferably at most 16 mol%.

Al₂O₃ is added in order to increase the stability, chemical durability and strength of glass. If the content of Al₂O₃ is less than 3 mol%, the glass is likely to be unstable. On the other hand, if the content of Al₂O₃ exceeds 8 mol%, the glass melting point or the glass transition point (Tg) is likely to be too high. The content of Al₂O₃ is preferably at least 4 mol%, more preferably at least 5 mol%. Further, the content of Al₂O₃ is preferably at most 7 mol%, more preferably at most 6 mol%.

CaO is added in order to increase the stability of glass or the precipitation property of crystals and to lower the glass melting temperature or the glass transition point (Tg). If the content of CaO is less than 9 mol%, the glass melting point is likely to be too high. On the other hand, if the content of CaO exceeds 23 mol%, the glass is likely to be unstable. The content of CaO is preferably at least 12 mol%, more preferably at least 13 mol%, particularly preferably at least 14 mol%. Further, the content of CaO is preferably at most 22 mol%, more preferably at most 21 mol%, particularly preferably at most 20 mol%.

K₂O or Na₂O is added in order to lower the glass transition point (Tg). If the total content of K₂O and Na₂O is less than 0.5 mol%, the glass melting point or the glass transition point (Tg) is likely to be too high. On the other hand, if the total content of K₂O and Na₂O exceeds 6 mol%, the chemical durability, particularly the acid resistance, is likely to deteriorate, and the electrical insulation property is also likely to deteriorate. The total content of K₂O and Na₂O is preferably from 0.8 mol% to 5 mol%.

The glass powder for substrate base body is not necessarily limited to only one comprising the above-described components and may contain other components within a range to satisfy various properties such as the glass transition point (Tg). When it contains such other components, their total content is preferably at most 10 mol%.

As such other components, SrO, BaO and Li₂O may, for example, be mentioned.

The glass powder for substrate base body can be obtained by producing a glass having the above-described glass composition by a melting method and grinding it by a dry grinding method or a wet grinding method. In the case of a wet grinding method, it is preferred to employ water as a solvent. The grinding can be carried out by using a grinding machine such as a roll mill, a ball mill or a jet mill.

The 50% particle size (D₅₀) of the glass powder for substrate base body is preferably from 0.5 µm to 2 µm, more preferably from 1 µm to 1.5 µm. If the 50% particle size of the glass powder for substrate base body is less than 0.5 µm, the glass powder is likely to cohere, whereby the handling tends to be difficult, and it tends to be difficult to uniformly disperse it. On the other hand, if the 50% particle size of the glass powder for substrate base body exceeds 2 µm, the glass softening temperature is likely to rise, or the sintering is likely to be inadequate. The particle size can be adjusted, for example, by classification which is carried out after the grinding, as the case requires.

On the other hand, as the ceramics filler, one which has been commonly used for the production of conventional LTCC substrates may be used without any particular restriction, and for example, an alumina powder, a zirconia powder, or a mixture of an alumina powder and a zirconia powder, may preferably be used. Further, the 50% particle size (D₅₀) of the ceramics filler is preferably e.g. from 0.5 µm to 4 µm, more preferably from 1 µm to 3 µm.

The above glass powder and the ceramics filler are blended and mixed, for example, so that the glass powder would be from 30 mass% to 50 mass%, preferably from 35 mass% to 45 mass%, and the ceramics filler would be from 50 mass% to 70 mass%, preferably from 55 mass% to 65 mass% to obtain a glass ceramics composition. To this glass ceramics composition, a binder, and as the case requires, a plasticizer, a solvent, etc. are added to obtain a slurry.

As the binder, for example, a polyvinyl butyral or an acrylic resin may be suitably used. As the plasticizer, for example, dibutyl phthalate, dioctyl phthalate or butylbenzyl phthalate may be employed. Further, as the solvent, an organic solvent such as toluene, xylene or butanol may suitably be employed.

The slurry thus obtained is formed into a sheet shape by e.g. a doctor blade method, followed by drying to produce a green sheet 2a for main body and a green sheet 2b for cover. With respect to the green sheet 2a for the main body, along with forming non-fired thermal vias 6, a non-fired external electrode terminal 4 and a non-fired via conductor 5 are formed to prepare a non-fired main body member 2A. Further, with respect to the green sheet 2b for cover, without forming the non-fired thermal via 6, only a non-fired connection terminal 3 and a non-fired via conductor 5 are formed to prepare a non-fired member 2B for cover.

The method for forming the non-fired external electrode terminal 4, etc. is not particularly restricted, and by a screen printing method, a metal paste is applied and filled. As the metal paste, for example, a paste prepared by adding a vehicle such as ethylcellulose and as the case requires, a solvent to a metal powder containing copper, silver, gold or the like as the main component may be used.

Further, in a case where a glass film 7 is formed, a part to be a mounting portion 22 of the non-fired covering member 2B is coated with a glass paste by a screen printing method to form a non-fired glass film 7. As such a glass paste, it is possible to employ one formed into a paste by adding a vehicle such as ethylcellulose, and as the case requires, a solvent, etc. to a glass powder (glass powder for glass film).

As the glass powder for the glass film, one which will be a film state glass when fired simultaneously with the non-fired main body member 2A and the non-fired covering member 2B, may be used. The 50% particle size (D₅₀) of the glass powder is preferably from 0.5 µm to 2 µm. Further, the surface roughness Ra of the glass film 7 may be adjusted, for example, by the particle size of the glass powder for the glass film. That is, it is possible to reduce the surface roughness Ra by using glass powder which can be sufficiently melted at the time of firing and which is excellent in flowability, as the glass powder for the glass film.

The non-fired main body member 2A and the non-fired cover member 2B are laminated and bonded by hot pressing to prepare a non-fired substrate 1 for light-emitting element. Then, the obtained non-fired substrate 1 for light-emitting element is subjected to binder burn out to remove the binder, etc. and, firing is carried out to sinter the glass ceramics composition, etc. to prepare a substrate 1 for light-emitting element.

The hot pressing may be carried out by a general known method. However, the hot pressing is carried out at from 50°C to 90°C, preferably from 60°C to 80°C. Depending on the temperature of the hot pressing, time of hot pressing is from 1 to 10 minutes, preferably 3 to 7 minutes.

The binder burn out can be carried out by holding the substrate, for example, at a temperature of from 500°C to 600°C for from 1 hour to 10 hours. If the binder burn out temperature is lower than 500°C, or the binder burn out time is less than 1 hour, the binder, etc. may not sufficiently be removed. On the other hand, when the binder burn out temperature is about 600°C, and the binder burn out time is about 10 hours, the binder, etc. can be sufficiently removed, and if the binder burn out temperature or time exceeding such a level, the productivity, etc. may deteriorate.

Further, the firing is carried out by maintaining a temperature of from 850°C to 900°C for from 20 minutes to 60 minutes, and it is particularly preferred to carry out the firing at a temperature of from 860°C to 880°C. If the firing temperature is lower than 850°C, or the firing time is less than 20 minutes, a dense fired product may not be obtained. On the other hand, when the firing temperature is about 900°C, and the firing time is about 60 minutes, a sufficiently dense fired product can be obtained. If the firing temperature is higher than 900°C, or the firing time is longer than 60 minutes, the productivity, etc. may deteriorate on the contrary. Further, if a metal paste containing a metal powder mainly containing silver is used, and if the firing temperature exceeds 880°C, firing shrinkage tends to be excessive, and a predetermined shape may not be maintained.

In the foregoing, the process for producing the substrate 1 for light-emitting element has been described, but the non-fired main body member 2A and the non-fired covering member 2B may not necessarily be composed of a single green sheet and may be one wherein a plurality of green sheets are laminated. Further, the order to form the respective components, etc. may also be suitably changed within a range where the production of the substrate 1 for light-emitting element is possible.

### EXAMPLES

Now, the present invention will be described in detail with reference to Examples. However, it should be understood that the present invention is by no means restricted to such Examples.

### (Examples 1 to 9)

Firstly, a green sheet for main body and a green sheet for cover were prepared. That is, raw materials were blended and mixed so that SiO₂ became 60.4 mol%, B₂O₃ 15.6 mol%, Al₂O₃ 6 mol%, CaO 15 mol%, K₂O 1 mol% and Na₂O 2 mol%, and this raw material mixture was put into a platinum crucible and melted at 1,600°C for 60 minutes. Then, this molten state glass was cast and cooled. This glass was ground by a ball mill made of alumina for 40 hours to obtain a glass powder for the substrate main body. Here, ethyl alcohol was used as the solvent at the time of grinding.

40 mass% of this glass powder for substrate main body and 60 mass% of an alumina filler (tradename: AL-45H manufactured by Showa Denko K.K.) were blended and mixed to prepare a glass ceramics composition. To 50 g of this glass ceramics composition, 15 g of an organic solvent (a mixture of toluene, xylene, 2-propanol and 2-butanol in a mass ratio of 4:2:2:1), 2.5 g of a plasticizer (di-2-ethylhexyl phthalate), 5 g of polyvinyl butyral (tradename: PVK #3000K manufactured by DENKI KAGAKU KOGYO KABUSHIKI KAISHA) as a binder and 0.5 g of a dispersing agent (tradename: BYK180 manufactured by BYK Japan K.K.) were blended and mixed for 1 hour by a ball-mill to prepare a slurry.

This slurry was applied on a PET film by a doctor blade method, and dried to obtain a green sheet for main body which would have a thickness of 0.85 mm after firing, and green sheets for cover which would have a thickness of 0.01 mm, 0.03 mm, 0.05 mm, 0.075 mm, 0.1 mm, 0.125 mm, 0.15 mm, 0.175 mm and 0.2 mm respectively after firing were prepared. The relationship between the thickness after firing, namely distance T and Examples 1 to 9 are mentioned in Table 1.

On the other hand, a conductive powder (tradename: S550 manufactured by Daiken Chemical Co., Ltd.) and ethyl cellulose as a vehicle were blended in a mass ratio of 85:15 and dispersed in α-terpineol as a solvent so that the solid content would be 85 mass%. Then, kneading was carried out in a porcelain mortar for 1 hour, and further, dispersion was carried out three times by a three roll mill to prepare a metal paste.

Through-holes having a diameter of 0.3 mm were formed in the green sheet for main body at portions corresponding to the mounting portion by means of a punching machine and filled with the metal paste by a screen printing method to form non-fired thermal vias, and at the same time, a non-fired external electrode terminal and a non-fired via conductor were formed to prepare a non-fired main body member 2A. Further, on the green sheet for cover, without forming a non-fired thermal via, only a non-fired external electrode terminal and a non-fired via conductor were formed to prepare a non-fired cover member 2B.

Then, the non-fired main body member 2A and the non-fired cover member 2B were laminated, and bonded by hot-press (60°C, 5 minutes) to prepare a non-fired substrate for light-emitting element. The non-fired substrate for light-emitting element was held at 550°C for 5 hours to carry out binder burn out and further held at 870°C for 30 minutes to carry out firing, to obtain a substrate 1 for light-emitting element.

### (Example 10)

Example 10 is an example in which a mixture of a ceramics filler, an alumina filler and a zirconia filler was used.

The same glass powder for substrate main body as in Examples 1 to 9 was used. 38 mass% of this glass powder for substrate main body, 38 mass% of an alumina filler (tradename: AL-45H manufactured by Showa Denko K.K.) and 24 mass% of zirconia filler (tradename: HSY-3F-J manufactured by Daiichi Kigenso Kagaku Kogyo Co., Ltd.) were blended and mixed for 1 hour by a ball-mill to prepare a glass ceramics composition. To 50 g of this glass ceramics composition, 15 g of an organic solvent (a mixture of toluene, xylene, 2-propanol and 2-butanol in a mass ratio of 4:2:2:1), 2.5 g of a plasticizer (di-2-ethylhexyl phthalate), 5 g of polyvinyl butyral (tradename: PVK #3000K manufactured by DENKI KAGAKU KOGYO KABUSHIKI KAISHA) as a binder and 0.5 g of a dispersing agent (tradename: BYK180 manufactured by BYK Japan K.K.) were blended and mixed for 1 hour by a ball-mill to prepare a slurry. This slurry was applied on a PET film by a doctor blade method, and dried to obtain a green sheet for cover, which would have a thickness of 0.1 mm after firing. A substrate for light-emitting element was produced in the substantially same manner as in Examples 1 to 9.

### (Examples 11 to 29)

A substrate for light-emitting element was produced in the substantially same manner as in Examples 1 to 9, except that the mounting portion was provided with a glass film having a surface roughness Ra shown in Table 1.

That is, after preparing a non-fired main body member 2A and a non-fired cover member 2B, a portion to be a mounting portion for the non-fired cover member 2B was coated with about 20 µm of a glass paste by screen printing, whereby a non-fired glass film was formed. The non-fired cover member 2B on which the non-fired glass film was formed was laminated to the non-fired main body member 2A, and they were bonded by hot-press (60°C, 5 minutes) to prepare a non-fired substrate for light-emitting element. The non-fired substrate for light-emitting element was subjected to the binder burn out and firing to obtain a substrate for light-emitting element.

Further, the glass powder for glass film used for preparing the glass paste was prepared as below. Firstly, raw materials were blended and mixed so that SiO₂ became 81.6 mol%, B₂O₃ 16.6 mol% and K₂O 1.8 mol%, and this raw material mixture was put into a platinum crucible and melted at 1,600°C for 60 minutes. Then, this molten state glass was cast and cooled. This glass was ground by a ball mill made of alumina for from 8 to 60 hours to obtain a glass powder for glass film.

60 mass% of the glass powder of glass film and 40 mass% of a resin component (containing ethyl cellulose and α-terpineol in a mass ratio of 85:15) were blended and kneaded in a porcelain mortar for 1 hour, and further, dispersion was carried out three times by a three roll mill to prepare a glass paste.

Further, the surface roughness Ra of the glass film was adjusted by the particle size of the glass powder for the glass film. Here, the particle size of the glass powder for the glass film was adjusted by grinding time by the ball mill. The larger the particle size of the glass powder for the glass film is, the larger the surface roughness Ra becomes, and the smaller the particle size of the glass powder for the glass film is, the smaller the surface roughness Ra becomes. When grinding is carried out for about 8 hours, the surface roughness Ra is made to be 1.0 µm, and when grinding is carried out for 12 hours, the surface roughness Ra is made to be 0.6 µm.

### (Comparative Examples 1 to 5)

A substrate for light-emitting element having a conventional structure such that thermal vias are exposed on both surfaces of a substrate main body was prepared. That is, through holes having a diameter of 0.3 mm were formed on a mounting portion of a green sheet of which the thickness would be 0.85 mm after firing, the through holes were filled with a metal paste by a screen printing method to form non-fired thermal vias, and then a non-fired electrode, etc. were formed to form a non-fired substrate for light-emitting element, followed by the binder burn out and firing to prepare a substrate for light-emitting element. Further, this substrate for light-emitting element was produced in the same manner basically as in Example 1, etc., except that thermal vias were formed so as to penetrate through the substrate main body, namely so as to penetrate through a green sheet for cover used in the present invention.

Next, with respect to the substrates for light-emitting element prepared in Examples and Comparative Example, the difference H in height of the mounting portion and in a case where the substrate was provided with a glass plate, the surface roughness Ra of the glass film were measured by a contact type surface roughness measuring instrument (tradename: SURFCOM 1400D, manufactured by Tokyo Seimitsu Co., Ltd.).

Further, the substrates for light-emitting element prepared in Examples and Comparative Examples were provided with light-emitting diode elements to measure heat resistance. That is, six light-emitting diode elements (tradename: GQ2CR460Z, manufactured by Showa Denko K.K.) which were connected in a series at a mounting portion were fixed with a die bond material (tradename: KER-3000-M2, manufactured by Shin-Etsu Chemical Co., Ltd.) and sealed with a sealing agent (tradename: SCR-1016A, manufactured by Shin-Etsu Chemical Co., Ltd.).

With respect to the substrates for light-emitting element which were provided with the light-emitting diode element, the heat resistance was measured by a thermal resistance-measuring device (tradename: TH-2167, manufactured by Minekoon Denki). Here, the applied electric current was 35 mA, and the current was applied until the voltage drop was saturated, whereupon the saturation temperature Tj (°C) was calculated by the temperature coefficient lead from the dropped voltage and the temperature-voltage drop properties of the light-emitting diode element.

In a case where the above-mentioned diode elements are used, the heat resistance is preferably at most 30°C/W, more preferably at most 25°C/W. If the heat resistance is higher than 30°C/W, the voltage drop becomes large, and the light extraction efficiency and the life span of the light-emitting diode elements may deteriorate.

Further, the deflective strength was measured by the following method. A green sheet which would be a thickness of 0.85 mm similarly to the green sheet used in Examples and Comparative Examples was subjected to binder burn out by holding the green sheet at 550°C for 5 hours. Then, the firing was carried out by holding the green sheet at 870°C for 30 minutes to prepare a fired product for the deflective strength test. The fired product for the deflective strength test was cut into strip specimens having a width of 5 mm, and three points flexural strength of the strip specimens was measured. Here, the span was 15 mm, and the cross head speed was 0.5 cm/min.

Table 1 shows the distance T from the mounting surface to the thermal vias, the difference H in height at the mounting portion, the surface roughness Ra of the glass film, and measured results of the heat resistance and the deflective strength. Further, numerical values mentioned as the distance T (mm) in Table 1 represent the thickness of the green sheet for cover after firing.

Here, "-" in Table 1 means an example that a mounting portion is not provided with a glass film.

**[Table 1]**

| | Distance T (mm) | Difference H in height (µm) | Surface roughness Ra (µm) | Deflective strength (MPa) | Heat resistance (°C/W) |
|---|---|---|---|---|---|
| Ex. 1 | 0.010 | 6.5 | - | 280 | 42 |
| Ex. 2 | 0.030 | 4.1 | - | 280 | 29 |
| Ex. 3 | 0.050 | 3.0 | - | 280 | 34 |
| Ex. 4 | 0.075 | 2.8 | - | 280 | 33 |
| Ex. 5 | 0.100 | 2.8 | - | 280 | 33 |
| Ex. 6 | 0.125 | 2.7 | - | 280 | 31 |
| Ex. 7 | 0.150 | 2.7 | - | 280 | 31 |
| Ex. 8 | 0.175 | 2.7 | - | 280 | 39 |
| Ex. 9 | 0.200 | 2.7 | - | 280 | 41 |
| Ex. 10 | 0.100 | 2.8 | - | 280 | 34 |
| Ex. 11 | 0.010 | 4.5 | 0.3 | 280 | 36 |
| Ex. 12 | 0.030 | 2.1 | 0.3 | 280 | 33 |
| Ex. 13 | 0.050 | 1.0 | 0.3 | 280 | 28 |
| Ex. 14 | 0.075 | 0.8 | 0.3 | 280 | 27 |
| Ex. 15 | 0.100 | 0.8 | 0.3 | 280 | 27 |
| Ex. 16 | 0.125 | 0.7 | 0.3 | 280 | 25 |
| Ex. 17 | 0.150 | 0.7 | 0.3 | 280 | 25 |
| Ex. 18 | 0.175 | 0.7 | 0.3 | 280 | 33 |
| Ex. 19 | 0.200 | 0.7 | 0.3 | 280 | 35 |
| Ex. 20 | 0.050 | 1.0 | 0.6 | 280 | 37 |
| Ex. 21 | 0.075 | 0.8 | 0.6 | 280 | 35 |
| Ex. 22 | 0.100 | 0.8 | 0.6 | 280 | 35 |
| Ex. 23 | 0.125 | 0.7 | 0.6 | 280 | 38 |
| Ex. 24 | 0.150 | 0.7 | 0.6 | 280 | 40 |
| Ex. 25 | 0.050 | 1.0 | 1.0 | 280 | 39 |
| Ex. 26 | 0.075 | 0.8 | 1.0 | 280 | 39 |
| Ex. 27 | 0.100 | 0.8 | 1.0 | 280 | 41 |
| Ex. 28 | 0.125 | 0.7 | 1.0 | 280 | 41 |
| Ex. 29 | 0.150 | 0.7 | 1.0 | 280 | 43 |
| Comp. Ex. 1 | The upper surface of thermal vias are exposed to the mounting portion | 8.0 | - | 280 | 46 |
| Comp. Ex. 2 | The upper surface of thermal vias are exposed to the mounting portion | 8.0 | - | 280 | 46 |
| Comp. Ex. 3 | The upper surface of thermal vias are exposed to the mounting portion | 8.0 | - | 280 | 46 |
| Comp. Ex. 4 | The upper surface of thermal vias are exposed to the mounting portion | 8.0 | - | 280 | 46 |
| Comp. Ex. 5 | The upper surface of thermal vias are exposed to the mounting portion | 8.0 | - | 280 | 46 |

It is evident from Table 1 that in the case of the substrates for light-emitting element prepared in Comparative Examples as a conventional structure, the difference H in height becomes high totally, and the heat resistance also becomes high. On the other hand, it is evident that in the case of the substrates for light-emitting element prepared in Examples as a structure such that thermal vias do not reach the mounting surface, the difference H in height is reduced totally, and the heat resistance also lowered. Particularly, in a case of a substrate having a distance T of from 0.05 mm to 0.15 mm, the difference H in height is at most 1 µm, and the heat resistance is also sufficiently low.

### INDUSTRIAL APPLICABILITY

According to a light-emitting device formed by providing the substrate for light-emitting element of the present invention with light-emitting elements, sufficient luminescence can be provided, damage and tilt of optical axis of the light-emitting elements can be reduced, and such a light-emitting device is useful as a backlight for e.g. mobile phones or liquid crystal displays, as illumination for automobiles or decorations, or as other light sources.

The entire disclosure of Japanese Patent Application No. 2009-259449 filed on November 13, 2009 including specification, claims, drawings and summary is incorporated herein by reference in its entirety.

### REFERENCE SYMBOLS

- 1:: Substrate for light-emitting element
- 2:: Substrate main body
- 6:: Thermal vias
- 10:: Light-emitting device
- 11:: Light-emitting element
- 21:: Mounting surface
- 22:: Mounting portion
- 23:: Non-mounting surface

## Claims

1. A substrate for light-emitting element, which comprises a substrate main body made of a sintered product of a glass ceramics composition comprising a glass powder and a ceramics filler and having a mounting surface, of which a part constitutes a mounting portion on which a light-emitting element is to be mounted, and thermal vias embedded in the substrate main body and extending from a non-mounting surface which is a surface opposite to the mounting surface to the vicinity of the mounting surface so as not to be in contact with the mounting surface.

2. The substrate for light-emitting element according to Claim 1, wherein the distance from the mounting surface to the thermal vias is from 0.05 mm to 0.15 mm.

3. The substrate for light-emitting element according to Claim 1, wherein the distance from the mounting surface to the thermal vias is from 0.05 mm to 0.20 mm.

4. The substrate for light-emitting element according to any one of Claims 1 to 3, wherein the difference in height between the highest part and the lowest part of the mounting portion is at most 1 µm.

5. The substrate for light-emitting element according to any one of Claims 1 to 4, wherein the mounting portion is provided with a glass film having a surface roughness Ra of at most 0.4 µm.

6. The substrate for light-emitting element according to any one of Claims 1 to 5, wherein the ceramics filler is an alumina powder, a zirconia powder or a mixture of an alumina powder and a zirconia powder.

7. The substrate for light-emitting element according to any one of Claims 1 to 6, wherein the substrate main body has a flexural strength of at least 250 MPa.

8. A light-emitting device comprising the substrate for light-emitting element as defined in any one of Claims 1 to 7, and a light-emitting element mounted thereon.
